Europäisches Patentamt

European Patent Office

Office européen des brevets

(11) Numéro de publication : **0 507 686 B1**

(12) **FASCICULE DE BREVET EUROPEEN**

(45) Date de publication du fascicule du brevet :
07.12.94 Bulletin 94/49

(51) Int. Cl.$^5$ : **H03L 7/081**

(21) Numéro de dépôt : **92400924.4**

(22) Date de dépôt : **02.04.92**

(54) **Dispositif automatique d'asservissement de la phase du signal en sortie d'un circuit.**

(30) Priorité : **05.04.91 FR 9104163**

(43) Date de publication de la demande :
**07.10.92 Bulletin 92/41**

(45) Mention de la délivrance du brevet :
**07.12.94 Bulletin 94/49**

(84) Etats contractants désignés :
**DE ES FR GB NL**

(56) Documents cités :
**EP-A- 0 370 877**
**GB-A- 2 110 893**
**1989 IEEE INTERNATIONAL SYMPOSIUM ON CIRCUITS AND SYSTEMS vol. 2, 8 Mai 1989, PORTLAND,OR pages 1411 - 1414; XU GUO-NAI ET AL.: 'NOVEL PHASE LOCKED LOOP WITH DIGITAL CONTROL TECHNIQUES'**

(73) Titulaire : **THOMSON-CSF**
**173, Boulevard Haussmann**
**F-75008 Paris (FR)**

(72) Inventeur : **Boulanger, Alain**
**THOMSON-CSF,**
**SCPI,**
**Cédex 67**
**F-92045 Paris la Défense (FR)**
Inventeur : **Guern, Pierre**
**THOMSON-CSF,**
**SCPI,**
**Cédex 67**
**F-92045 Paris la Défense (FR)**

(74) Mandataire : **Chaverneff, Vladimir et al**
**THOMSON-CSF**
**SCPI**
**B.P. 329**
**50, rue Jean-Pierre Timbaud**
**F-92402 Courbevoie Cédex (FR)**

EP 0 507 686 B1

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

Jouve, 18, rue Saint-Denis, 75001 PARIS

## Description

La présente invention se rapporte à un dispositif automatique d'asservissement de phase d'un circuit.

On connaît d'après la demande de brevet français 88 15411 publiée sous le numéro 2 639 775 un dispositif d'asservissement de phase utilisé en particulier pour une chaîne d'amplification en classe C. Ce dispositif comporte une ou plusieurs boucles d'asservissement. L'ajustement des temps de propagation entre chaîne directe et chaîne de retour y est effectué manuellement. Ce dispositif fonctionne très bien, mais le pré-positionnement des boucles d'asservissement doit y être effectué manuellement, ce qui ne permet pas une interchangeabilité totale du circuit à asservir en phase.

La présente invention a pour objet un dispositif d'asservissement de la phase d'un signal de sortie d'un circuit sur la phase du signal d'entrée de ce circuit, dispositif permettant un pré-positionnement automatique, qui soit capable de converger en pratiquement toutes circonstances, qui assure un asservissement même en cas de variations très lentes et monotones de perturbations de phase, sur une très large gamme de fréquences, avec un temps de verrouillage de la correction des perturbations très court.

Le dispositif conforme à l'invention comprend une boucle, dite "lente", comportant en cascade une ligne à retard, un amplificateur, un déphaseur, un inverseur 0/180°, un filtre et un dispositif de détection de dépassement de seuils de phase et de contrôle d'inverseur.

La présente invention sera mieux comprise à la lecture de la description détaillée de plusieurs mode de réalisation, pris à titre d'exemples non limitatifs et illustrés par le dessin annexé, sur lequel :

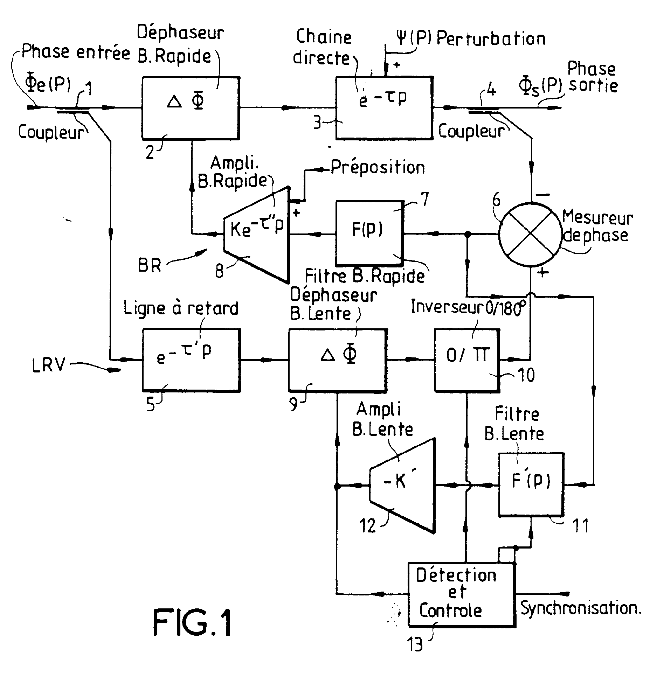

- La figure 1 est un schéma synoptique de principe d'un dispositif d'asservissement conforme à l'invention ;
- la figure 2 est un schéma synoptique d'un mode de réalisation du dispositif conforme à l'invention ;
- la figure 3 est un schéma synoptique d'une variante du dispositif conforme à l'invention ;
- les figures 4 à 6 sont des schémas équivalents de diverses parties du dispositif de l'invention ; et
- la figure 7 est un schéma synoptique d'un autre mode de réalisation du dispositif de l'invention.

Le système d'asservissement de phase de l'invention est de préférence constitué de deux boucles d'asservissement, une boucle rapide et une boucle lente. La boucle rapide assure la correction des perturbations rapides du type transitoires et bruits de phase dont les variations sont prises en compte, dans le cas d'un traitement Doppler, et donc indésirables. Elle doit donc être très rapide afin de conserver une bande de correction la plus large possible, d'autre part, elle doit être suffisamment stable au sens de l'amortissement pour ne pas générer elle-même des pulsations parasites. Dans le même ordre d'idées, elle doit être peu bruyante afin de ne pas ramener plus de bruit de phase qu'elle n'en corrige. La boucle lente a pour fonction de permettre à la boucle rapide de fonctionner dans les meilleures conditions possibles. Elle doit égaliser les retards entre chaîne directe et référence de façon à assurer la convergence de la boucle rapide. Elle doit aussi égaliser la phase de façon à ramener la moyenne de la différence de phase en milieu de la caractéristique de rattrapage de la boucle rapide, afin de procurer à cette dernière la plage de correction et l'efficacité maximum.

La boucle lente assure ainsi les meilleures conditions de fonctionnement à la boucle rapide pour la plus large plage possible de valeurs de perturbation et de retard de propagation de la chaîne directe.

Elle garantit parallèlement l'interchangeabilité des éléments de la chaîne directe. Cependant, le fonctionnement de la boucle lente ne doit pas être perçu par le traitement Doppler, et donc sa constante de temps doit être très supérieure à la plus grande récurrence analysée par le traitement.

Le système d'asservissement est constitué tout d'abord d'une boucle rapide BR comprenant un déphaseur de boucle rapide 2, une chaîne directe 3, un coupleur 4, un mesureur de déphasage 6, un filtre de boucle rapide 7, et un amplificateur de boucle rapide 8.

La phase d'entrée $\Phi_e(\rho)$ est corrigée de $\Delta\Phi$ à l'aide du déphaseur de boucle rapide 2, dans la chaîne directe. La chaîne directe 3 est modélisée en caractéristiques de phase par un retard de propagation $\tau$ et une perturbation $\Psi(\rho)$. La phase de sortie de la chaîne directe 3 est prélevée à l'aide d'un coupleur 4. La différence entre la valeur mesurée en sortie de la chaîne directe 3 et la consigne est effectuée au moyen d'un mesureur de phase 6. Ce signal d'erreur est ensuite filtré à l'aide d'un filtre de boucle rapide 7 de fonction de transfert $F(\rho)$. Ce signal est ensuite amplifié par l'amplificateur de boucle rapide 8. On a modélisé l'ensemble : mesureur de déphasage 6, filtre de boucle rapide 7, amplificateur de boucle rapide 8 par une fonction de transfert $F(\rho)$, un gain K et un retard de propagation $\tau''$. On peut éventuellement injecter un signal de prépositionnement afin d'améliorer les performances de la boucle rapide. Le signal de correction de la boucle rapide est enfin réinjecté dans la chaîne directe à l'aide du déphaseur de boucle rapide 8.

La consigne de la boucle rapide est générée au niveau de l'ensemble coupleur 1, ligne à retard 5, déphaseur boucle lente 9, inverseur 0/180° et mesureur de déphasage 6.

La phase d'entrée $\Phi_e(\rho)$ est prélevée en entrée de la chaîne directe de façon à générer le signal de consigne. Ce signal est différé dans le temps d'un re-

tard $\tau'$ à l'aide d'une ligne à retard 5. Il est ensuite déphasé au travers du déphaseur de boucle lente 9 et de l'inverseur 0/180° 10. L'ensemble LRV comprenant la ligne à retard 5, le déphaseur de boucle lente 9 et l'inverseur 0/180° 10 constitue une ligne à retard variable. Enfin l'ajustement du retard utilisé pour générer la consigne est contrôlé par la boucle lente constituée de l'ensemble déphaseur de boucle lente 9, inverseur 0/180° 10, filtre de boucle lente 11, amplificateur de boucle lente 12 et de son dispositif de détection et contrôle 13.

Pour cette boucle lente, la correction à effectuer est l'égalisation des temps de propagation entre la chaîne directe et le trajet du signal de consigne dans la boucle rapide. Pour cela on utilise la phase de sortie $\Phi_S(\rho)$ comme signal de consigne de la boucle lente et on asservit le signal en sortie de l'inverseur 0/180° sur cette phase au moyen de la boucle lente. L'écart de phase ainsi obtenu en sortie du mesureur de déphasage 6 est tout d'abord filtré à l'aide du filtre de boucle lente 11 puis amplifié par l'amplificateur de boucle lente 12. Le signal ainsi obtenu est réinjecté dans l'ensemble LRV de ligne à retard variable au moyen du déphaseur de boucle lente 9. Comme, avec des performances légèrement dégradées, on peut verrouiller cette boucle en phase à $2k\Pi$ radians près, la ligne à retard variable comporte une ligne à retard 5 fixe et un déphaseur de boucle lente 9 de dynamique finie. Le dispositif de détection et de contrôle 13 détermine l'état du déphaseur de boucle lente 9 d'après la valeur du signal de contrôle de celui-ci issu de l'amplificateur de boucle lente 12. A partir de cette information, le dispositif détection et contrôle 13 génère deux actions ponctuelles dans le temps. Si le déphaseur arrive en butée, ce qui correspond à un rattrapage de phase proche de + ou - $\Pi$ radians, le dispositif 13 déphase le signal de + ou - $\Pi$ radians à l'aide de l'inverseur 0/180° 10. Simultanément, il force la valeur du déphasage introduit par le déphaseur de boucle lente 9 à 0 en agissant sur le filtre de boucle lente 11. La boucle lente s'asservit donc sur la même phase qu'avant l'action du dispositif de détection et de contrôle 13 mais à $2\Pi$ radians près et en ayant ramené le déphaseur de boucle lente 9 en milieu de caractéristique.

Le fait d'asservir à $2k\Pi$ radians près (k entier) de la valeur idéale ne dégrade l'efficacité de la boucle lente que si la fréquence du signal d'entrée dont la phase est $\Phi_e(\rho)$ change rapidement sur une large bande de fréquences. L'efficacité de la boucle rapide n'est pas forcément dégradée mais sa dynamique de rattrapage est plus limitée du fait qu'elle doit rattraper à la fois la perturbation $\Psi(\rho)$ introduite par la chaîne directe 3 et les sauts de phase dus aux actions conjuguées de l'agilité de fréquence en entrée et de la différence de temps de propagation entre la chaîne directe 3 et la consigne de la boucle rapide asservie à $2k\Pi$ près.

On va maintenant décrire de façon détaillée le dispositif 13 de détection et de contrôle qui assure la convergence à $2k\Pi$ près de la boucle lente, et permet ainsi au dispositif d'asservissement d'obtenir une efficacité maximale de la correction effectuée par la boucle rapide.

On notera que la boucle lente peut fonctionner de façon autonome, sans la boucle rapide.

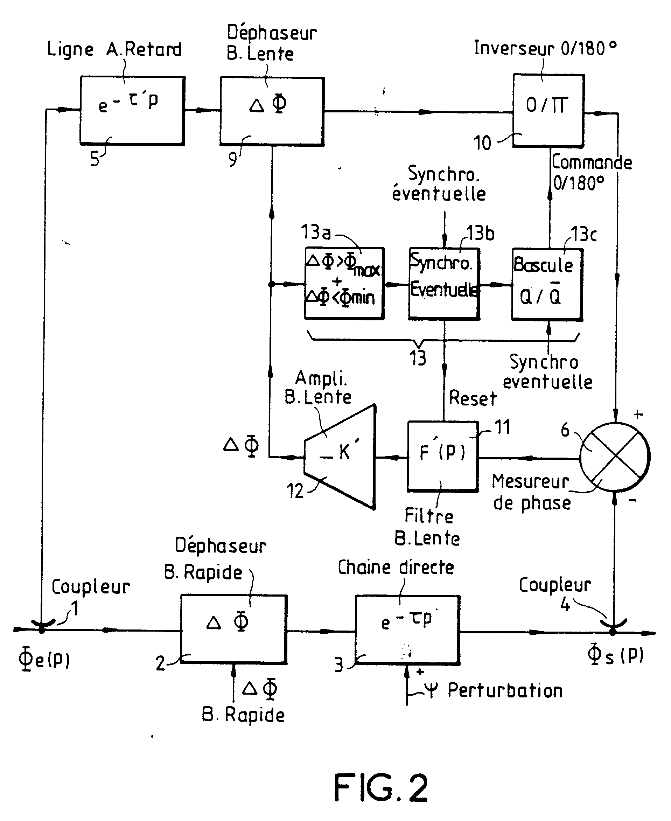

On a représenté en figure 2 les détails de réalisation du dispositif 13, ainsi que les éléments du dispositif d'asservissement nécessaires aux explications.

La boucle lente doit s'asservir à $2k\Pi$ près sur la phase de consigne de boucle lente $\Phi_S(\rho)$ ;

$$\Phi_S(\rho) = \Phi_e(\rho) + \Delta\Phi \text{ moyen} + \Psi \text{ moyen}$$

La phase d'entrée $\Phi_e(\rho)$ est prélevée au moyen du coupleur 1. Cette phase d'entrée est différée d'un retard $\tau'$ équivalent au retard de propagation $\tau$ de la chaîne directe 3. Le mesureur de déphasage 6 génère un signal d'erreur qui est filtré et amplifié à l'aide du filtre de boucle lente 11 et de l'amplificateur de boucle lente 12. Le signal résultant est réinjecté sous la forme d'un déphasage $\Delta\Phi$ dans le déphaseur de boucle lente 9. Si ce déphasage $\Delta\Phi$ vient à approcher les butées du déphaseur, le dispositif de détection et contrôle 13 entre en action.

Cette action est mise en oeuvre par trois sous-ensembles 13a à 13c que comporte le dispositif 13. Le sous-ensemble 13a, du type comparateur, détecte si le déphasage $\Delta\Phi$ excède des valeurs limites $\Phi$max, $\Phi$min fixées à la dynamique du déphaseur (moins une certaine marge de sécurité). Le signal logique ainsi généré est éventuellement synchronisé avec un signal extérieur à la boucle lente au moyen du dispositif 13b. Le signal résultant est utilisé pour la remise à zéro de la valeur intégrée par le filtre de boucle lente 11. Conjointement, on bascule un dispositif de type flip-flop 13c qui pilote l'inverseur 0/180° 10. La bascule 13c peut également recevoir, si nécessaire, un signal de synchronisation.

Il résulte de l'injection du signal d'erreur dans le déphaseur 9 et de l'action du dispositif 13 sur l'inverseur 10 que la boucle lente s'asservit sur la valeur de consigne, avant l'action du dispositif 13 (à $\pm 2\Pi$ radians près), le déphaseur 9 étant positionné en milieu de caractéristique.

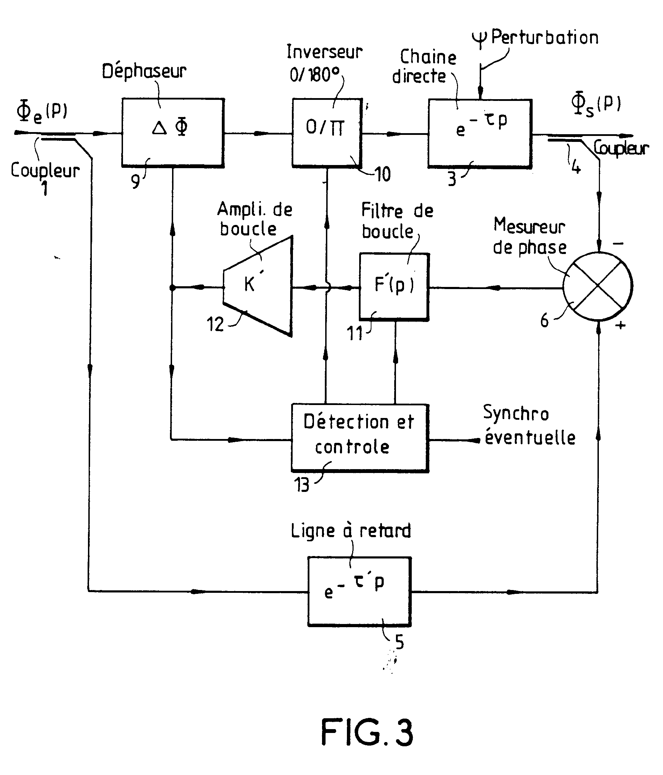

Selon la variante représentée en figure 3, la boucle lente peut fonctionner de façon autonome (sans boucle rapide). La voie principale comprend : le déphaseur 9, l'inverseur 0/180° 10 et la chaîne directe 3 (qui est susceptible d'être soumise à des perturbations $\Psi$). Un coupleur 1 prélève la phase d'entrée et est relié par une ligne à retard (retard $\tau'$) au mesureur de phase 6, qui est relié par ailleurs au coupleur de sortie 4. Le signal d'erreur du mesureur de phase 6 est envoyé, via le filtre de boucle 11, à l'amplificateur de boucle lente 12 dont la sortie est reliée au déphaseur 9 et au dispositif de détection et de contrôle 13.

Ce dispositif 13 est relié au filtre 11 et à l'inverseur 10, et peut recevoir éventuellement un signal de synchronisation.

On notera que, dans le cas de l'utilisation d'une boucle rapide et d'une boucle lente, dans la boucle rapide le filtre 7 de boucle rapide peut soit être un composant spécifique, soit résulter des caractéristiques de limitation de la bande passante des composants utilisés par d'autres circuits de la boucle. Le déphaseur de boucle rapide peut être soit analogique (à déphasages continus), soit numérique à déphasages discrets, soit une combinaison des deux. Le traitement mis en oeuvre par le filtre 7 de boucle rapide et l'amplificateur 8 de boucle rapide peut être soit analogique, soit numérique, soit une combinaison des deux, et ce traitement peut se faire en mode échantillonné/bloqué. On peut lui adjoindre éventuellement un signal de prépositionnement.

On remarquera également que dans la boucle rapide, l'ordre des éléments 7 et 8 est arbitraire. La boucle lente est constituée par : le coupleur 1, la ligne à retard 5, le déphaseur 9, l'inverseur 0/180°, le filtre 11, l'amplificateur 12 et le dispositif de détection et de contrôle 13. Dans cette boucle, le filtre 11 peut soit être un composant spécifique, soit résulter des caractéristiques de limitation de la bande passante des composants utilisés pour d'autres circuits de la boucle. Le déphaseur 9 peut être soit analogique à variation continue des déphasages, soit numérique à variation discrète des déphasages, soit une combinaison des deux. L'inverseur 0/180° peut être soit un déphaseur, soit un inverseur logique. L'ordre des éléments 5, 9 et 10 est arbitraire.

Le traitement mis en oeuvre par : le filtre 11, et l'amplificateur 12 peut être analogique ou numérique, ou une combinaison des deux, ou bien encore en mode échantillonné/bloqué.

L'ordre des éléments de la chaîne de boucle lente filtre 11 et amplificateur 12 est arbitraire.

Ainsi, le dispositif selon l'invention s'asservit automatiquement à 2kΠ radians près sur la phase du signal d'entrée sans que l'on ait à procéder à un ajustement manuel ou à un ajustement cas par cas. Dans ce dispositif, le circuit 13 assure la convergence à 2kΠ radians près de la boucle lente. Ce circuit 13 génère à partir de l'information de l'état du déphaseur 9 des actions ayant pour finalité la convergence de la boucle lente. La première action consiste à introduire un déphasage supplémentaire de + ou - 180° par commande de l'inverseur 10. La seconde action consiste à forcer ponctuellement à zéro la valeur intégrée par le filtre 11. La résultante de ces deux actions est que la boucle lente s'asservit à 2Π radians près sur la phase de milieu de caractéristique du déphaseur 9. En d'autres termes, le dispositif de l'invention tend à égaliser automatiquement les délais de propagation entre chaîne à asservir (comportant l'élément 3) et chaîne de consigne (boucle lente).

Le dispositif de l'invention peut être mis en oeuvre par exemple pour le contrôle de la fonction de transfert en phase d'une chaîne d'amplification à composants à état solide ou à tube (Magnétron, Klystron, ...), pour un déphaseur asservi, dans un dispositif de modulation/démodulation de phase, pour la formation de faisceaux à déphaseurs asservis, etc.

Dans un exemple de réalisation, mis en oeuvre dans une chaîne d'émission classe C, en bande S présentant les caractéristiques suivantes : agilité de fréquence de l'ordre de 15%, retard de propagation de l'ordre de 40 ns, rotation de phase pendant l'impulsion émise de l'ordre de 100° (mode d'émission pulsé), on a obtenu, avec le dispositif de l'invention : convergence automatique de la boucle lente garantie à 100%, gain de correction sur les transitoires de phase de l'ordre de 14 dB sur toute la bande, temps d'asservissement de la boucle rapide (délais de propagation compris) de l'ordre de 200 ns, temps de montée de la boucle rapide de l'ordre de 80 ns, bande passante de la boucle rapide d'environ 5 MHz, et gamme d'amplitude de correction de la boucle rapide pour un temps de verrouillage dégradé d'un facteur 4 : environ ± 170°.

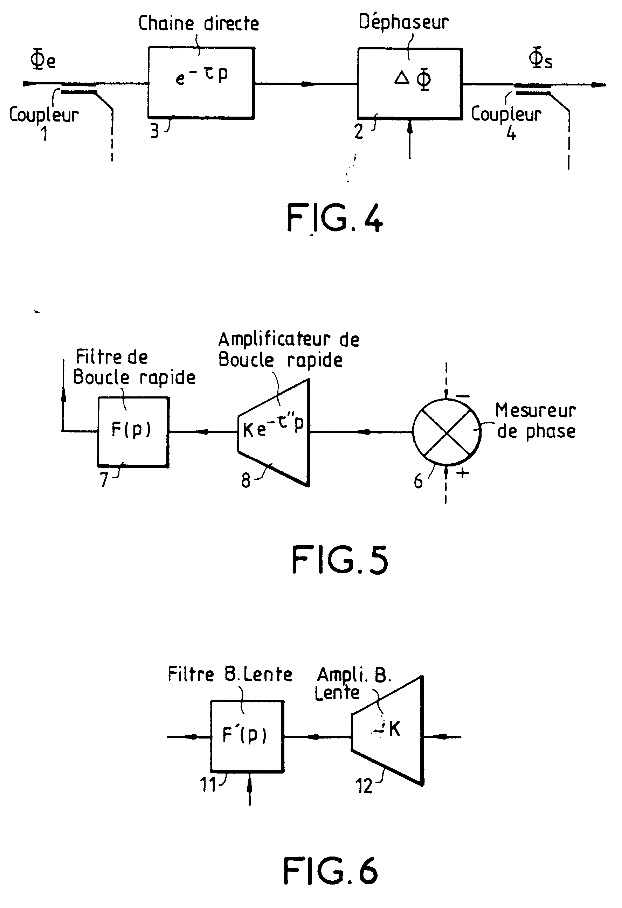

On a représenté en figure 4 le schéma équivalent de la chaîne directe. Il comporte, entre le coupleur d'entrée 1 et le coupleur de sortie 4, la chaîne directe 3 présentant un retard $\tau$ et le déphaseur 2, apportant un déphasage de $\Delta\Phi$. L'ordre des éléments 2 et 3 est sans importance.

Le schéma équivalent de la boucle rapide de la figure 5 comprend : le mesureur de phase 6, l'amplificateur de boucle rapide 8 (de retard $\tau''$ et de gain K) et le filtre de boucle rapide 7 (de fonction de filtrage F).

Le schéma équivalent de boucle lente, représenté en figure 6, comprend l'amplificateur 12 de boucle lente (de gain K) et le filtre 11 (de fonction de filtrage F').

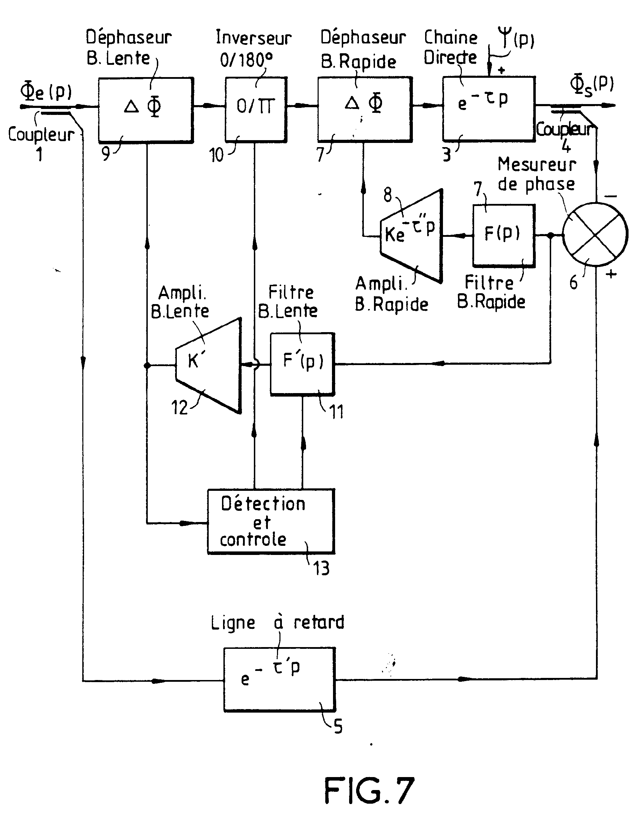

On a représenté en figure 7 le bloc-diagramme de principe d'une variante du dispositif de l'invention, selon laquelle la boucle lente agit sur le facteur de correction global, du fait que certains de ses éléments sont insérés dans la chaîne directe.

Dans ce circuit de la figure 7, la chaîne directe comprend, entre le coupleur d'entrée 1 et le coupleur de sortie 4, le déphaseur de boucle lente 9, l'inverseur 0/180° 10, le déphaseur de boucle rapide 7 et la chaîne directe 3. Entre les coupleurs 4 et 1, on branche le mesureur de phase 6 et la ligne à retard 5. La sortie du mesureur de déphasage 6 est reliée d'une part à une boucle rapide comportant le filtre 7 et l'amplificateur 8, et d'autre part à la boucle lente comportant le filtre 11 et l'amplificateur 12 et aux entrées de l'inverseur 10 et du filtre 11.

## Revendications

1. Dispositif automatique d'asservissement de la phase d'un signal de sortie d'un circuit sur la phase du signal d'entrée de ce circuit, dispositif du type comportant au moins une boucle d'asservissement en dérivation sur le circuit à asservir (3), caractérisé par le fait qu'il comprend une boucle dite "lente" comportant une ligne à retard (5), un amplificateur (12), un déphaseur (9), un inverseur 0/180° (10), un filtre (11) et un dispositif (13) de détection de dépassement de seuils de phase et de contrôle d'inverseur.

2. Dispositif selon la revendication 1, caractérisé par le fait que le dispositif de détection et de contrôle comprend un circuit (13a) de détection de dépassement de seuils de phase relié à la sortie (12) de l'amplificateur de la boucle "lente", et relié à l'entrée d'une bascule (13c) commandant l'inverseur 0/180°.

3. Dispositif selon la revendication 2, caractérisé par le fait qu'un circuit de synchronisation (13b) sur signal extérieur est inséré entre le circuit de détection (13a) et la bascule (13c).

4. Dispositif selon l'une des revendications précédentes, caractérisé par le fait qu'un mesureur de déphasage (6) est disposé entre la sortie (4) du circuit à asservir et la ligne à retard (5) et est relié à l'entrée de la boucle "lente".

5. Dispositif selon l'une des revendications précédentes, caractérisé par le fait que le filtre résulte des caractéristiques de limitation de bande passante des composants utilisés par d'autres circuits de la boucle.

6. Dispositif selon l'une des revendications précédentes, caractérisé par le fait qu'il est associé à une boucle d'asservissement "rapide" (2, 7, 8) assurant la correction des perturbations rapides du type transitoire et bruits de phase.

7. Dispositif selon la revendication 6, caractérisé par le fait que des éléments (9, 10) de la boucle "lente" sont insérés dans le circuit asservi.

## Claims

1. Automatic arrangement for locking the phase of an output signal of a circuit to the phase of the input signal of this circuit, an arrangement of the type including at least one servocontrol loop branched to the circuit to be locked (3), characterized in that it comprises a so-called "slow" loop including a delay line (5), an amplifier (12), a phase shifter (9), a 0/180° inverter (10), a filter (11) and an arrangement (13) for phase threshold overshoot detection and inverter control.

2. Arrangement according to Claim 1, characterized in that the detection and control arrangement comprises a phase threshold overshoot detection circuit (13a) connected to the output (12) of the amplifier of the "slow" loop, and connected to the input of a flip-flop (13c) operating the 0/180° inverter.

3. Arrangement according to Claim 2, characterized in that a circuit (13b) for synchronization with an external signal is inserted between the detection circuit (13a) and the flip-flop (13c).

4. Arrangement according to one of the preceding claims, characterized in that a phase shift meter (6) is arranged between the output (4) of the circuit to be locked and the delay line (5) and is connected to the input of the "slow" loop.

5. Arrangement according to one of the preceding claims, characterized in that the filter results from the passband limitation characteristics of the components used by other circuits of the loop.

6. Arrangement according to one of the preceding claims, characterized in that it is associated with a "fast" servocontrol loop (2, 7, 8) providing for the correction of the fast disturbances of the transient and phase noise type.

7. Arrangement according to Claim 6, characterized in that elements (9, 10) of the "slow" loop are inserted into the locked circuit.

## Patentansprüche

1. Automatische Vorrichtung zur Regelung der Phase eines Ausgangssignals einer Schaltung auf die Phase des Eingangssignals dieser Schaltung, wobei diese Vorrichtung von dem Typ ist, der wenigstens eine Regelschleife parallel zu der zu regelnden Schaltung (3) aufweist, dadurch gekennzeichnet, daß sie eine sogenannte "langsame" Schleife mit einer Verzögerungsleitung (5), einem Verstärker (12), einem Phasenschieber (9), einem 0/180°-Umschalter (10), einem Filter (11) und einer Einrichtung (13) zum Erfassen der Überschreitung von Phasenschwellenwerten und zur Steuerung des Umschalters aufweist.

2. Vorrichtung nach Anspruch 1, dadurch gekennzeichnet, daß die Einrichtung zur Erfassung und zur Steuerung eine Schaltung (13a) zum Erfassen der Überschreitung von Phasenschwellenwerten aufweist, die mit dem Ausgang (12) des Verstärkers der "langsamen" Schleife und mit dem Eingang eines Kippglieds (13c) verbunden ist, das den 0/180°-Umschalter steuert.

3. Vorrichtung nach Anspruch 2, dadurch gekennzeichnet, daß eine Schaltung (13b) zur Synchronisierung mit einem äußeren Signal zwischen die Erfassungsschaltung (13a) und das Kippglied (13c) eingefügt ist.

4. Vorrichtung nach einem der vorhergehenden Ansprüche, dadurch gekennzeichnet, daß ein Phasenverschiebungsmesser (6) zwischen dem Ausgang (4) der zu regelnden Schaltung und der Verzögerungsleitung (5) angeordnet und mit dem Eingang der "langsamen" Schleife verbunden ist.

5. Vorrichtung nach einem der vorhergehenden Ansprüche, dadurch gekennzeichnet, daß sich das Filter aus den Charakteristika der Begrenzung des Durchlaßbereichs der Bauteile ergibt, die von anderen Schaltungen der Schleife verwendet werden.

6. Vorrichtung nach einem der vorhergehenden Ansprüche, dadurch gekennzeichnet, daß sie einem "schnellen" Regelkreis (2, 7, 8) zugeordnet ist, der die Korrektur von schnellen Störungen des transienten Typs und Phasenrauschen ermöglicht.

7. Vorrichtung nach Anspruch 6, dadurch gekennzeichnet, daß Elemente (9, 10) der "langsamen" Schleife in die geregelte Schaltung eingefügt sind.

FIG.1

FIG. 2

Déphaseur

Inverseur
0/180°

Chaine
directe

$\Psi$ Perturbation

$\Phi_e(p)$

$\Delta \Phi$

$0/\pi$

$e^{-\tau p}$

$\Phi_s(p)$

Coupleur

Coupleur
1

9

10

3

4

Ampli. de
boucle

Filtre de
boucle

Mesureur
de phase

K'

F'(p)

12

11

6

−

+

Détection et
controle

Synchro
éventuelle

13

Ligne à retard

$e^{-\tau' p}$

5

## FIG.3

Chaine directe

Déphaseur

$\Phi_e$

Coupleur
1

$e^{-\tau p}$

3

$\Delta \Phi$

2

$\Phi_s$

Coupleur
4

## FIG. 4

Filtre de
Boucle rapide

Amplificateur de
Boucle rapide

$F(p)$

7

$Ke^{-\tau'' p}$

8

Mesureur
de phase

6

## FIG. 5

Filtre B. Lente

Ampli. B.
Lente

$F'(p)$

11

$-K$

12

## FIG. 6

FIG.7